# EUROPEAN PATENT APPLICATION

(11) **EP 4 739 072 A1**
(43) Date of publication of application: **06.05.2026**
(21) Application number: 25210774.3
(22) Date of filing: 23.10.2025
(51) Int. Cl.: H10W 70/685, H10W 70/05, H10W 70/692, H10W 70/695

(54) **PACKAGING SUBSTRATE**

(30) Priority: 29.10.2024 US 202463713080 P
(71) Applicant: Absolics Inc., Covington, GA 30014 (US)
(72) Inventor: KIM, Sungjin, Covington, Georgia, 30014 (US); KIM, Jincheol, 18469 Hwaseong-si, Gyeonggi-do (KR)
(74) Representative: BCKIP Part mbB

(57) **Abstract**

The embodiment relates to a packaging substrate comprising: a glass wafer 20; a plurality of vias 25 disposed in the glass wafer 20; copper electrodes 40 disposed on the vias 25 or on the surface of the glass wafer 20; and an insulating layer 30 surrounding the vias 25 or the copper electrodes 40.

The packaging substrate 100 comprises P and Zn as eluted impurities, and the content of the eluted impurities is based on an analysis value obtained by preparing an analytical solution through pretreatment at 200°C for 16 hours in a graphite block after adding 70 mol% nitric acid to the packaging substrate 100, and analyzing the solution using an ICP-MS device (Nexlon2000 model manufactured by PerkinElmer) in accordance with KS M 0025:2008 test method. The content of P (by weight) is 1,500 ppb or less, and the content of Zn (by weight) is 500 ppb or less.

## Description

This application claims priority of U.S. Provisional Patent Application No. 63/713,080, filed on October 29, 2024.

### BACKGROUND

### TECHNICAL FIELD

The embodiment relates to a packaging substrate and the like.

### DESCRIPTION OF RELATED ART

In the manufacture of electronic components, the process of forming circuits on a semiconductor wafer is generally called the front-end (FE) process, whereas assembling the processed wafer into a form suitable for end products is known as the back-end (BE) process. The packaging operation is comprised in the back-end process.

The four pillars that have propelled the rapid progress of modern electronic products are semiconductor technology, semiconductor packaging technology, manufacturing-process technology, and software. Although semiconductor technology has achieved sub-micron line widths, tens of millions of transistors, high-speed operation, and substantial heat dissipation, the packaging technologies required to fully support these advances have not evolved at the same pace. Consequently, a semiconductor device's overall electrical performance is often dictated more by its packaging and electrical interconnects than by the device's intrinsic characteristics.

Materials commonly used for packaging substrates include ceramics and resins. Ceramic substrates-for example, silicon-based ceramics-exhibit high resistivity and high dielectric constants, which renders them less suitable for mounting high-performance, high-frequency semiconductor devices. Resin substrates, on the other hand, can accommodate such high-performance, high-frequency devices, but they offer limited capability for reducing the wiring pitch.

Glass substrates have recently emerged as promising candidates for high-end packaging. By forming through-vias in the glass and filling them with conductive material, the interconnect path between the semiconductor device and the motherboard can be shortened, thereby enabling superior electrical performance.

Related art includes Korean Patent Publication No. 10-2023-0038664.

### SUMMARY

In some embodiments, a packaging substrate, and a method for manufacturing it, in which the impurity content is reduced is provided.

According to the embodiments, a packaging substrate according to an embodiment includes: a glass wafer; a plurality of vias disposed in the glass wafer; copper electrodes disposed on the vias or on the surface of the glass wafer; and an insulating layer surrounding the vias or the copper electrodes.

The packaging substrate comprises P and Zn as eluted impurities.

The content of the eluted impurities is determined by preparing an analytical solution in which 70 mol% nitric acid is added to the packaging substrate and pretreated in a graphite block at 200°C for 16 hours, and analyzing the analytical solution using an ICP (inductively coupled plasma)-MS device (Nexlon2000 model manufactured by PerkinElmer) in accordance with KS M 0025:2008 test method.

The content of P (by weight) may be 1,500 ppb or less.

The content of Zn (by weight) may be 500 ppb or less.

A seed layer may further be disposed beneath the copper electrodes.

The seed layer may include copper and titanium.

The insulating layer may include a polymer resin and inorganic particles.

The inorganic particles may include silica.

The polymer resin may include at least one selected from the group consisting of epoxy resin, acrylic resin, urethane resin, and combinations thereof.

The packaging substrate may have a polyhedral shape overall.

Two to four faces among the six faces of the polyhedron may expose cut surfaces.

The glass wafer may include borosilicate-based plate glass.

The eluted impurities may further include Si and B.

The weight ratio of Si to B may be in the range of 1:5 to 7.

The analysis of eluted impurities may include the intensity of B and the intensity of F.

The intensity ratio of the F peak based on the B peak may be 50 or less.

The eluted impurities may further include B and Ti.

The weight ratio of B to Ti may be in the range of 1:50 to 70.

The eluted impurities may further include Al.

The content of Al (by weight) may be 900 ppb or less.

The eluted impurities may further include B.

The weight ratio of B to Zn may be in the range of 1:2 to 5..

The weight ratio of B to P may be in the range of 1:5 to 30.

### BRIEF DESCRIPTION OF THE DRAWINGS

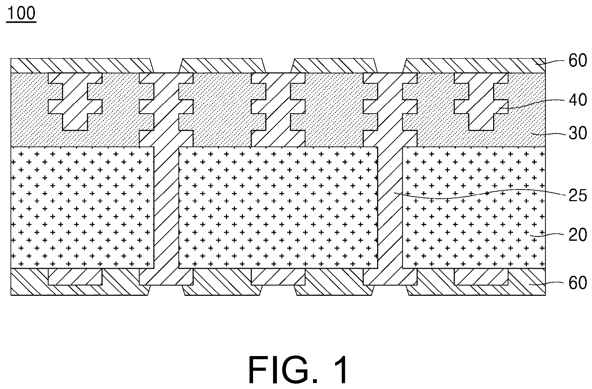

Fig. 1 is a schematic cross-sectional view illustrating the structure of a packaging substrate according to an embodiment.

### DESCRIPTION OF THE EMBODIMENTS

The following embodiments are explained in detail with reference to the accompanying drawings, so that those skilled in the art may readily practice the invention. Nevertheless, the invention may be embodied in various forms and is not confined to the specific examples provided herein. Throughout the specification, like reference numerals indicate like elements.

In this specification, the phrase "combinations thereof," when used in a Markush grouping, refers to any mixture or combination containing at least one of the components listed in the group.

The terms "first," "second," "A," "B," and similar designations appearing in this specification are used solely to distinguish between elements bearing the same name. Unless the context expressly dictates otherwise, terms in the singular are to be construed as encompassing the plural.

In this specification, the expression "~-based" denotes a compound that contains the referenced component or a derivative thereof.

As used herein, the phrase "B is located on A" encompasses both situations in which B directly contacts A and situations in which one or more intervening layers are interposed between them; accordingly, it should not be construed as requiring direct contact with the surface of A.

As used herein, the phrase "B is connected to A" embraces both direct connections between A and B and connections made through one or more intermediate components, unless expressly stated otherwise; it should therefore not be construed as requiring a direct link.

Unless the context clearly requires otherwise, terms expressed in the singular throughout this specification are intended to encompass both singular and plural forms.

The packaging substrate provides mechanical support for mounting semiconductor elements, with support members, electrodes, insulators, and other materials arranged in prescribed patterns. It also functions as an electrical interface between the semiconductor element and the power supply, rectifying the current delivered to the element and thereby enhancing the stability of the electronic device.

Although the electrode position and thickness-whether vertical or horizontal-may vary with the design, the basic structure comprises forming an electrically conductive pattern on a support substrate and depositing an insulating layer over it.

As packaging substrates advance toward finer line widths and higher levels of integration, precise electrode formation alone is not enough-rigorous impurity control becomes paramount. If an element present in region A readily migrates to region B and degrades the latter's function, the substrate may fall short of its intended performance. Furthermore, the influence of such impurities must be assessed not only immediately after fabrication but also throughout the device's service life under diverse operating environments, thereby necessitating enhanced long-term stability.

Fig.1 is a schematic cross-sectional view illustrating the structure of a packaging substrate according to an embodiment. The following description provides a detailed explanation of the embodiment with reference to the Fig 1.

A packaging substrate 100 according to an embodiment comprises: a glass wafer 20; a plurality of vias 25 disposed in the glass wafer 20; copper electrodes 40 disposed on the vias 25 or on the surface of the glass wafer 20; and insulating layers 30 surrounding the vias 25 or the copper electrodes 40.

The glass wafer 20 is formed of plate-shaped glass, and may comprise plate glass for semiconductor applications. For example, the glass wafer 20 may be a borosilicate-based plate glass. Borosilicate glass is a type of glass that comprises silica and boron trioxide. Commercial products are available from companies such as Schott, Corning, and Asahi Glass, although the glass wafer 20 of the embodiment is not limited thereto.

A plurality of vias 25 may be disposed in the glass wafer 20.

Each via 25 penetrates through the glass wafer 20, forming a passage that connects the upper and lower surfaces, and may be filled with an electrode or the like described later.

The vias 25 may be formed by processes such as etching or melting.

For example, defects may be formed in the glass wafer 20 using a laser, followed by wet etching to form the vias.

The electrodes may comprise, for example, copper electrodes 40. The copper electrodes refer to copper plating layers or copper alloy layers arranged in a predetermined electrode shape, and are not limited to electrodes composed solely of copper. In other words, the embodiment illustrates copper electrodes as an example of an electrically conductive layer. The term "copper electrode" is used to broadly refer to metal conductive layers applied to packaging substrates, and is not limited to electrodes made exclusively of copper but should be interpreted as including electrodes containing copper. In addition, materials other than copper may be comprised within the scope of rights as long as the spirit of the invention is not impaired.

The copper electrodes may be formed by plating. For example, electroless copper plating may be used, although the invention is not limited thereto.

The copper electrodes may be formed after applying a seed layer prior to plating, depending on the need. The seed layer promotes the formation of the plating layer, and may comprise, for example, an inorganic seed layer such as a titanium sputtered layer, or an organic seed layer containing copper seed, although not limited thereto.

The insulating layer is formed during the process of forming the copper electrodes 40, and serves to prevent short circuits between the copper electrodes 40.

The insulating layer may comprise a mixture of inorganic particles and a polymer resin.

For example, the inorganic particles may comprise silica particles.

For example, the polymer resin may comprise at least one selected from the group consisting of epoxy resin, acrylic resin, urethane resin, and combinations thereof. The polymer resin may comprise at least one selected from the group consisting of epoxy resin, acrylic resin, urethane resin, and combinations thereof.

The insulating layer may comprise, for example, an Ajinomoto Build-up Film (ABF), although it is not limited thereto.

In the embodiment, the impurity content of the packaging substrate 100 may be measured as eluted impurities.

The content of the eluted impurities is determined by preparing an analytical solution by adding 3 ml of 70 mol% nitric acid to 0.43 g of the packaging substrate 100 and pretreating it in a graphite block at 200°C for 16 hours. The analytical solution is then analyzed using an ICP (inductively coupled plasma)-MS device (Nexlon2000 model manufactured by PerkinElmer) in accordance with the KS M 0025:2008 test method. The program used for the analysis is the Syngistix for ICP-MS software (version 3.2) provided by the manufacturer, with the settings applied in Standard Mode.

The packaging substrate 100 comprises P and Zn as eluted impurities.

Specifically, the content of Phosphorus (P), expressed by weight (and applicable hereinafter) may be 1,500 ppb or less. The content of P may also be 1,400 ppb or less, 1,300 ppb or less, 1,200 ppb or less, 1,100 ppb or less, or 1,000 ppb or less. The content of P may be 200 ppb or more, 300 ppb or more, 400 ppb or more, 500 ppb or more, or 600 ppb or more.

Phosphorus (P) is believed to originate from polymer layers-such as insulating or resist layers-present in the packaging substrate. P can also enhance thermal stability and chemical resistance. When the P content in the eluted impurities falls within the range noted above, the thermal stability of the substrate's insulating layer can be improved. Even under repeated exposure to high-temperature environments, the substrate's chemical durability may be maintained. Moreover, the electrodes' strength, conductivity, and processability can remain within their desired ranges, yielding a packaging substrate with excellent overall physical properties.

The content of Zinc (Zn) may be 500 ppb or less, expressed by weight (and applicable hereinafter). The Zn content may also be 450 ppb or less, 400 ppb or less, 350 ppb or less, or 300 ppb or less. The Zn content may be 200 ppb or more, or 220 ppb or more.

Zinc (Zn) can act as a corrosion inhibitor for metal components such as electrodes. By protecting copper and other metallic electrodes from oxidation, Zn helps preserve low electrical resistance and efficient signal transmission, thereby enhancing circuit stability. When the Zn content in the eluted impurities is held within the range noted above, the electrodes' peel-off resistance and heat resistance remain within the desired limits, yielding a packaging substrate with superior physical properties.

The eluted impurities may further comprise Si.

The content of Silicon (Si) may be 120 ppb or less, 110 ppb or less, 100 ppb or less, 90 ppb or less, 80 ppb or less, 70 ppb or less, 60 ppb or less, 50 ppb or less, 40 ppb or less, or 30 ppb or less. The content of Si may be 3 ppb or more, 5 ppb or more, or 7 ppb or more.

Si is one of the main components of the glass wafer. Si is also a component of silica, which may be applied as inorganic particles in the insulating layer. When the content of Si in the eluted impurities falls within the above-described range, a packaging substrate with stable physical properties and minimal loss of inorganic components may be achieved.

The eluted impurities may further comprise B (boron).

The content of B may be 250 ppb or less, 220 ppb or less, 180 ppb or less, 150 ppb or less, 120 ppb or less, 110 ppb or less, 100 ppb or less, 90 ppb or less, 80 ppb or less, or 70 ppb or less. The content of B may be 10 ppb or more, 20 ppb or more, 30 ppb or more, 40 ppb or more, or 50 ppb or more.

B is one of the main components of the glass wafer. When the content of B in the eluted impurities falls within the above-described range, a packaging substrate with stable physical properties and minimal elution of inorganic components may be achieved.

The eluted impurities may further comprise Titanium (Ti).

The content of Ti may be 7,000 ppb or less, 6,500 ppb or less, 6,000 ppb or less, 5,500 ppb or less, or 5,000 ppb or less. The content of Ti may be 1,000 ppb or more, 1,500 ppb or more, 2,000 ppb or more, 2,500 ppb or more, or 3,000 ppb or more.

Ti is believed to originate from elements used in the electrode formation process. After forming the seed layer, unnecessary parts may be removed or selectively retained as needed. When the content of Ti in the eluted impurities falls within the above-described range, a packaging substrate with high integration and excellent durability may be achieved.

The eluted impurities may further comprise Al (aluminum).

The content of Al may be 900 ppb or less, 800 ppb or less, 700 ppb or less, 600 ppb or less, 500 ppb or less, 400 ppb or less, or 300 ppb or less. The content of Al may be 50 ppb or more, 60 ppb or more, 70 ppb or more, 80 ppb or more, 90 ppb or more, or 100 ppb or more.

Al may be applied to electrodes or the seed layer of electrodes. Al may influence the redistribution of signals and power in redistribution layers, and is associated with the electrical performance of the substrate. In addition, Al may form an oxide layer (Al₂O₃) to suppress corrosion or damage of electrodes, thereby maintaining long-term performance stability, and may also assist in heat dissipation depending on its placement. When the content of Al in the eluted impurities falls within the above-described range, a packaging substrate with improved electrode durability and excellent physical properties may be achieved.

The weight ratio of Si to B in the eluted impurities may be in the range of 1:5 to 7. The ratio may further be in the range of 1:5.5 to 6.5. When the impurities have such a ratio, a packaging substrate with excellent mechanical and electrical stability may be obtained.

The weight ratio of B to Ti in the eluted impurities may be in the range of 1:50 to 70. The ratio may further be in the range of 1:52 to 68 or 1:55 to 63. When the impurities have such a ratio, a packaging substrate with excellent electrical stability may be obtained.

The weight ratio of B to Zn in the eluted impurities may be in the range of 1:2 to 5. The ratio may further be in the range of 1:2.5 to 4.5 or 1:3 to 4. When the impurities have such a ratio, a packaging substrate with excellent electrical and mechanical stability may be obtained.

The weight ratio of B to P in the eluted impurities may be in the range of 1:5 to 30. The ratio may further be in the range of 1:8 to 25 or 1:10 to 20. When the impurities have such a ratio, a packaging substrate with excellent process stability and electrical stability may be obtained.

The weight ratio of B to Al in the eluted impurities may be in the range of 1:1 to 5. The ratio may further be in the range of 1:1.5 to 4 or 1:2.5 to 3.5. When the impurities have such a ratio, a packaging substrate with excellent electrical stability and thermal integrity may be obtained.

The eluted impurities may comprise F (fluorine).

In the analysis value of the eluted impurities, it is preferable that the intensity of F may be less than or equal to a certain ratio based on the intensity of B. Specifically, the intensity ratio of the F peak based on the B peak may be 50 or less. The intensity ratio may further be 45 or less, 40 or less, 37 or less, or 36 or less. The intensity ratio may be 1 or more, 15 or more, or 25 or more.

F is believed to originate from hydrofluoric acid or similar agents used during etching or cleaning processes. F is considered one of the causes of delamination between the glass wafer and the electrode or between the glass wafer and the insulating layer; therefore, it is preferable to sufficiently remove F. When the intensity ratio is within the above-described range, the occurrence of delamination during the manufacturing or usage process may be substantially suppressed, and a packaging substrate with enhanced durability may be obtained.

The eluted impurities may be measured by using a pretreated analytical solution prepared from a sample of the packaging substrate 100.

The packaging substrate 100 may have a rectangular plate shape with a standard thickness and may be generally polyhedral in form. Electrodes and insulating layers may be formed on the top and bottom surfaces. Furthermore, a cover layer 60 having an insulating function and exposing the electrodes at predetermined positions may be disposed on top. The cover layer 60 may comprise a polyimide layer, but is not limited thereto. The cover layer 60 may also comprise a solder resist layer, but is not limited thereto.

The packaging substrate 100 may be used as-is or cut to a desired size for preparing the analytical solution. For example, the substrate 100 may be diced before the analytical solution is prepared. Dicing can be performed by methods commonly employed in semiconductor dicing processes. Alternatively, laser cutting may be used; however, the choice of cutting technique is not limited to these examples.

For example, at least two of the four sides (excluding the top and bottom surfaces) may expose cut surfaces. In such cross-sections, at least a portion of the glass wafer, insulating layer, or cover layer may be exposed.

An experimental example is described below.

A redistribution layer was formed on a borosilicate glass wafer having a thickness of approximately 500 µm or more and a core. The redistribution layer was formed by repeating stacking and etching processes according to a conventional method used for forming redistribution layers. A titanium sputtered layer was used as a seed layer, ABF (manufactured by Ajinomoto) was used as the insulating layer, and a copper plating method was used to form the copper electrode layer. Cleaning was performed at each step with sufficient frequency according to Korean Patent Publication No. 10-2023-0038664.

The packaging substrate having the above-described configuration was cut into a sample with dimensions of 1 cm in width, 1 cm in length, and a mass of 0.43 g using a glass cutter.

The sample was pretreated by adding approximately 3 ml of nitric acid and heating it in a graphite block at 200°C for 16 hours. The resulting solution was collected and used as the analytical solution for qualitative analysis. Analysis was performed using an ICP (inductively coupled plasma)-MS device in accordance with the KS M 0025:2008 test method. The ambient temperature during the analysis was approximately 24°C, and the relative humidity was 64%.

The analysis equipment used was the Nexlon2000 model manufactured by PerkinElmer, and the analysis software was Syngistix for ICP-MS, version 3.2, provided by the manufacturer, with Standard Mode settings applied. The detection range was from 0.001 ppb.

As a result of the measurements, the Cu concentration was so high that it was recorded as overrange.

The intensity of P was 4,704,002, and the concentration (in ppb) was 924.992.

The intensity of Zn was 2,875,872, and the concentration was 246.577 ppb.

The intensity of Si was 250,872,550, and the concentration was 11.563 ppb.

The intensity of B was 1,780,351, and the concentration was 68.828 ppb.

The intensity of Ti was 179,196,692, and the concentration was 4,054.503 ppb.

The intensity of Al was 14,637,243, and the concentration was 201.417 ppb.

The intensity of F was 60,556,883.

The content ratio of B based on Si was approximately 5.95.

The content ratio of Ti based on B was approximately 58.9.

The content ratio of B based on Si was approximately 5.95.

The content ratio of P based on B was approximately 13.5.

The content ratio of Zn based on B was approximately 3.58.

The content ratio of Al based on B was approximately 2.93.

The intensity ratio of F based on B was approximately 34.

The packaging substrate having such characteristics may maintain excellent physical properties even in environments where repeated heating and cooling occur, thereby providing a high-performance packaging substrate.

The above measurements were conducted using packaging substrate samples from which separately mounted leads or semiconductor elements were removed, and thus the measured values represent the substrate itself without components such as encapsulation layers and/or leads. Specifically, the samples consisted of the glass substrate, redistribution layer, and a cover layer (with a polyimide layer on the top surface and a solder resist layer on the bottom surface).

The packaging substrate according to the embodiment comprises a low content of eluted impurities or maintains the ratio of specific impurities within a predetermined range, thereby providing a packaging substrate with improved thermal stability, electrical stability, and electrical conductivity.

Although the preferred embodiments of the present invention have been described in detail above, the scope of the present invention is not limited thereto, and various modifications and improvements made by those skilled in the art based on the basic concept defined in the following claims also fall within the scope of the present invention.

## Claims

1. A packaging substrate comprising:
a glass wafer;
a plurality of vias disposed in the glass wafer;
copper electrodes disposed on the vias or on the surface of the glass wafer; and
an insulating layer surrounding the vias or the copper electrodes,
wherein the packaging substrate comprises P and Zn as eluted impurities,
wherein the content of the eluted impurities is based on an analysis value obtained by preparing an analytical solution through pretreatment for 16 hours at 200°C in a graphite block after adding 70 mol% nitric acid to the packaging substrate, and analyzing the solution using an ICP (inductively coupled plasma)-MS device (Nexlon2000 model manufactured by PerkinElmer) in accordance with KS M 0025:2008 test method,
wherein the content of P (by weight) is 1,500 ppb or less, and
wherein the content of Zn (by weight) is 500 ppb or less.

2. The packaging substrate of claim 1,
wherein a seed layer is further comprised beneath the copper electrodes,
wherein the seed layer comprises copper and titanium,
wherein the insulating layer comprises a polymer resin and inorganic particles,
wherein the inorganic particles comprise silica, and
wherein the polymer resin comprises at least one selected from the group consisting of epoxy resin, acrylic resin, urethane resin, and combinations thereof.

3. The packaging substrate of claim 1 or claim 2,
wherein the packaging substrate has a polyhedral shape overall, and
wherein 2 to 4 faces among the six faces of the polyhedron expose cut surfaces.

4. The packaging substrate of any one from claim 1 to claim 3,
wherein the glass wafer is a borosilicate-based plate glass.

5. The packaging substrate of claim 4,
wherein the eluted impurities further comprise Si and B, and
wherein the weight ratio of the content of Si to B is in the range of 1:5 to 7.

6. The packaging substrate of claim 4 or claim 5,
wherein the analysis value of the eluted impurities comprises the intensities of B and F, and
wherein the intensity ratio of the F peak based on the B peak is 50 or less.

7. The packaging substrate of any one from claim 4 to claim 6,
wherein the eluted impurities further comprise B and Ti, and
wherein the weight ratio of the content of B to Ti is in the range of 1:50 to 70.

8. The packaging substrate of any one from claim 1 to claim 7,
wherein the eluted impurities further comprise Al, and
wherein the content of Al (by weight) is 900 ppb or less.

9. The packaging substrate of any one from claim 1 to claim 8,
wherein the eluted impurities further comprise B, and
wherein the weight ratio of the content of B to Zn is in the range of 1:2 to 5.

10. The packaging substrate of any one from claim 1 to claim 9,
wherein the weight ratio of the content of B to P is in the range of 1:5 to 30.
